# EUROPEAN PATENT APPLICATION

(11) **EP 4 482 267 A1**
(43) Date of publication of application: **25.12.2024**
(21) Application number: 24175484.5
(22) Date of filing: 13.05.2024
(51) Int. Cl.: H05K 7/14, H05K 7/20

(54) **MIXED-WIDTH CIRCUIT CARD ASSEMBLY THERMAL CHIMNEY**

(30) Priority: 11.05.2023 US 202318316034
(71) Applicant: Hamilton Sundstrand Corporation, Charlotte, NC 28217-4578 (US)
(72) Inventor: TROTMAN, Alexander, Granby, CT (US); TROTMAN, Kenneth J., Granby, CT (US)
(74) Representative: Dehns

(57) **Abstract**

Apparatus and associated methods relate to dividing single full-width card slot of an electronics enclosure into two reduced-width card slots. Such conversion is performed by interposing a card-slot dividing member (98) between full-width slide members (44a, 44b; 46a, 46b; 48a, 48b) on opposite interior surfaces of a card cage of the electronics enclosure. The card-slot dividing member has first and second reduced-width slide members (102a, 102b) aligned directly opposite the full-width slide members on opposite interior surfaces of the card cage. Each of the first and second reduced-width slide members is configured to slidably guide a reduced-width Circuit Card Assembly (CCA) module into the reduced-width card slot cooperatively with a corresponding one of the full-width slide members. In some embodiments, the card-slot dividing member is further configured to operate as a heat exchanger, helping to cool any CCA modules within an interior cavity of the electronics enclosure.

## Description

### BACKGROUND

Circuit Card Assembly (CCA) modules refer to Printed Circuit Boards (PCBs) that are arranged in card racks of electronics enclosures that provide mechanical integrity and electrical interconnectivity between the PCBs card racks of the electronics enclosures. Such electronics enclosures typically have openings for a specific number of CCA modules, into or out of these openings, the CCA modules are inserted or extracted, respectively. The CCA modules are typically guided into the electronics enclosures via slide rails at two opposite sides of the electronics enclosures. One or more electrical connectors at a backplane of the electronics enclosure receive corresponding electrical connectors of the CCA modules. Electrical connections between the CCA modules, and even circuitry, are often provided by a PCB of the backplane. Such a backplane PCB provides the electronics that interconnect the various CCA modules in the desired way. In some embodiments, instead of a backplane PCB, a cable simply provides interconnection with a remote electronic system.

Various standards govern various CCA modules, such as, for example, VMEbus. Such standards specify physical dimensions of CCA modules, locations of card interfaces, etc. The VMEbus standard provides for three different widths (i.e., the dimension of the CCA module between the slide rails): 3U, 6U, and 9U. A 3U CCA module is 100 mm in width, a 6U CCA module is 233 mm in width, and a 9U CCA module is 360 mm in width. Such standards provide for various sizes of CCA modules. Because these widths between the slide rails are so different, typically differently sized CCA modules use different sized electronics enclosures. In this way, an electronics enclosure can have a simple orthorhombic shape (i.e., having a rectangular cross section in each of the primary cross-sectional directions). Thus, when a system designer selects a specific one of the standardized sizes, the electronics enclosure corresponding to that selected size is typically used to house the system. Should a system designer select more than one of the standardized sizes, typically multiple electronics enclosures will be used for the system, at least one electronics enclosure for each size selected.

Heat dissipation is another consideration of the system designer, for powered CCA modules can generate significant heat. To dissipate the heat generated by the CCA modules within assemblies, sides of the electronics enclosures are often open or filled with apertures so that ambient air can freely move through the electronics enclosures housing the CCA modules, thereby convectively cooling the PCBs. For some applications, however, electronics enclosures are sealed so as to prevent ambient air from entering therein. For example, when designed to operate in harsh environments, sensitive CCA modules are isolated therefrom by sealed electronics enclosures.

### SUMMARY

Some embodiments relate to a Circuit Card Assembly (CCA) module adapter for a card cage of an electronics enclosure. The CCA module adapter includes a card-slot dividing member, a pair of electronics enclosure-engagement members, and a pair of reduced-width slide members. The card-slot dividing member longitudinally extends between a first end and a second end and configured to be located directly between a pair full-width slide members coupled to opposite lateral sides of the card cage that define a full-width card slot therebetween. The pair of electronics enclosure-engagement members includes first and second electronics enclosure-engagement members at the first and second ends of the card-slot dividing member and configured to couple to a top face and a backplane face of the Electronics enclosure, respectively. The pair of reduced-width slide members includes first and second reduced-width slide members coupled to the card-slot dividing member such that, when the card-slot dividing member is located directly between the first and second full-width slide members. The first reduced-width slide member is opposite the first full-width slide member, thereby defining a first reduced-width card slot. The second reduced-width slide member is opposite the second full-width slide member, thereby defining a second reduced-width card slot

Some embodiments relate to a Card Circuit Assembly (CCA), the CCA includes an electronics enclosure, a card cage, and a CCA module adapter. The electronics enclosure isolates an interior cavity from an exterior environment. The electronics enclosure has a top face and backplane face opposite to the top face. The card cage is within the electronics enclosure. The card cage has a plurality of full-width card slots therewithin. Each full-width card slot is defined between a pair of full-width slide member. The pair includes a first full-width slide member coupled to a first lateral side of the card cage and second full-width slide member opposite the first full-width slide member on a second lateral side opposite the first lateral side of the card cage. Each of the pair of full-width slide members configured to slidably guide a full-width PCB module therebetween. The CCA module adapter includes a card-slot dividing member and a pair of reduced-width slide members. The card-slot dividing member longitudinally extends between a first end having a first electronics enclosure engagement member coupled to the top face and a second end having a second electronics enclosure engagement member coupled to the backplane face. The card-slot dividing member is located directly between the pair of full-width slide members of a divided one of the full-width card slots. Each of the pair of reduced-width slide members is coupled to an opposite side of the card-slot dividing member, each pairing with one of the pair of full-width slide members of the divided one of the full-width card slots, thereby defining a reduced-width card slot therebetween. Each reduced-width card slot includes one of the full-width slide members of the divided one of the full-width card slot and one of the pair of reduced-width slide members there-opposite.

Some embodiments relate to a method for converting a PCB-module space of an electronics enclosure Card Circuit Assembly (CCA) so as to receive two PCB modules. In the method, a top face is coupled to a backplane face via first and second electronics enclosure engagement members at first and second ends of a card-width reducing member, respectively. The card-width reducing member is located directly between corresponding slide members on opposite interior surfaces of the electronics enclosure. In the method, a PCB module inserted into and/or removed from an interior cavity of the electronics enclosure is slidably guided via first and second PCB-module slide members coupled to the card-width reducing members together with the corresponding slide members on the opposite interior surfaces of the electronics enclosure. An electronics enclosure width defined between the corresponding slide members on the opposite interior surfaces of the electronics enclosure is reduced by the card-width reducing member and two PCB modules having reduced card widths can be slidably received within the electronics enclosure.

### BRIEF DESCRIPTION OF THE DRAWINGS

FIGS. 1A and 1B are perspective views of example CCA modules.
FIGS. 2A and 2B are plan views of electronics enclosures for the CCA modules depicted in FIGS. 1A and 1B, respectively.
FIGS. 3A and 3B are perspective views of an electronics enclosure that is configured to receive mixed-width CCA modules.
FIG. 4 is a sectional perspective view of the electronics enclosure depicted in FIGS. 3A and 3B.
FIG. 5 is a plan view of the electronics enclosure depicted in FIG. 3B.

### DETAILED DESCRIPTION

Apparatus and associated methods relate to dividing single full-width card slot of an electronics enclosure into two reduced-width card slots. Such conversion is performed by interposing a card-slot dividing member between full-width slide members on opposite interior surfaces of a card cage of the electronics enclosure. The card-slot dividing member has first and second reduced-width slide members aligned directly opposite the full-width slide members on opposite interior surfaces of the card cage. Each of the first and second reduced-width slide members is configured to slidably guide a reduced-width Circuit Card Assembly (CCA) module into the reduced-width card slot cooperatively with a corresponding one of the full-width slide members. In some embodiments, the card-slot dividing member is further configured to operate as a heat exchanger, helping to cool any CCA modules within an interior cavity of the electronics enclosure.

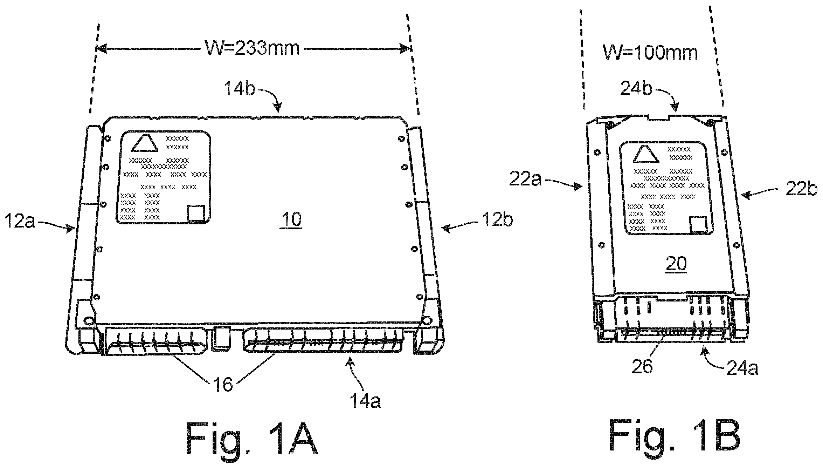

As described above, various standard size CCA modules can be accommodated within an electronics enclosure, but typically an electronics enclosure is designed to receive CCA modules that all have the same width. For example, an electronics enclosure can be designed to receive a predetermined number N of PCB modules, each of standard width W. Thus, all of the PCB modules received within the electronics enclosure have the same width W. FIGS. 1A and 1B are perspective views of example PCB modules. In FIG. 1A, PCB module 10 conforms to the VMEbus 6U standard for PCB modules. The card width W specified by the VMEbus 6U standard is 233 mm. To conform with this standard, PCB module 10 has lateral sides 12a and 12b which are opposite one another. Distance between opposite lateral sides 12a and 12b define a width W of PCB module 10. Lateral sides 12a and 12b are configured to slidably engage complimentary slide engagement members on opposite lateral sides of a card cage configured to receive PCB module 10. PCB module 10 is typically inserted into the electronics enclosure by inserting connector side 14a first into the card cage, while engaging lateral sides 12a and 12b with the complementary slide engagement members on opposite lateral sides of the card cage. In some embodiments, a user inserts PCB module 10 while holding side 14b, which is opposite connector side 14a, and guiding sides 12a and 12b into complementary slide engagement members on the opposite lateral sides of the electronics enclosure. The user continues to insert PCB module 10 until connector(s) 16, located at connector side 14a, makes mechanical and electrical connection with a complementary connector located at a backplane face of the electronics enclosure.

In FIG. 1B, PCB module 20 conforms to the VMEbus 3U standard for PCB modules. The card width W specified by the VMEbus 3U standard is 100 mm, which is less than one-half of the card width (i.e., 233 mm) specified by the VMEbus 6U standard. To conform with this VMEbus 3U standard, PCB module 20 has lateral sides 22a and 22b which are opposite one another. Distance between opposite lateral sides 22a and 22b define a width W of PCB module 20. Sides 22a and 22b are configured to slideably engage complimentary slide engagement members on opposite lateral sides of a card cage configured to receive PCB module 20. Again, PCB module 20 is typically inserted into the electronics enclosure by inserting connector side 24a into the card cage, while engaging lateral sides 22a and 22b with the complementary slide engagement members on opposite lateral sides of the card cage. In some embodiments, a user inserts PCB module 20 while holding side 24b, which is opposite connector side 24a, and guiding sides 22a and 22b into complementary slide engagement members on the opposite lateral sides of the electronics enclosure. The user continues to insert PCB module 20 until connector(s) 26, located at connector side 24a, makes mechanical and electrical connection with a complementary connector located at a backplane face of the electronics enclosure.

Although PCB modules 10 and 20 are shown as adhering to VMEbus standards, CCA modules adhering to various other standards can be accommodated by the methods and apparatus disclosed herein.

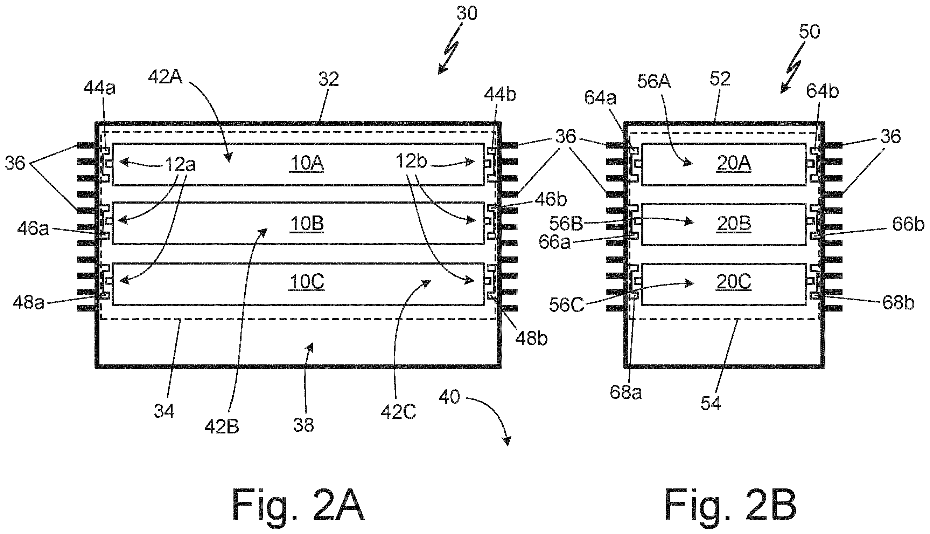

FIGS. 2A and 2B are plan views of CCA assemblies for the PCB modules depicted in FIGS. 1A and 1B, respectively. In FIG. 2A, CCA assembly 30 includes electronics enclosure 32, card cage 34, and external fins 36. In some applications, CCA assembly 30 is located in an environment that can be harmful to sensitive electronic equipment. In such applications, electronics enclosure 32 can sealably isolate interior cavity 38 from exterior environment 40, thereby protecting any sensitive electronic components therewithin from harmful exterior environment 40. Isolating interior cavity 38 from exterior environment 40, however, makes cooling of the sensitive electronic equipment more difficult, as the air from exterior environment 40 cannot be used as a fluid for direct convective cooling of the electronic equipment housed within electronics enclosure 32. To facilitate cooling of electronic equipment housed within electronics enclosure 32, electronics enclosure 32 has external fins 36 projecting from an exterior surface of electronics enclosure 32. Cooling of electronics enclosure 32 can be further facilitated, as will be described below.

Card cage 34 has three full-width card slots 42A, 42B and 42C. The term "full-width" describes the width of PCB modules that can be received between pairs of slide members 44a and 44b, 46a and 46b, and 48a and 48b, which are located on opposite lateral sides 46a and 46b of card cage 34. A distance between such pairs of slide members 44a and 44b, 46a and 46b, and 48a and 48b define the "full width" term that corresponds to card cage 34. For card cage 34, as depicted in FIG. 2A, the term "full width" corresponds to a width of PCB module 10 (as depicted in FIG. 1A) adhering to the VMEbus 6U standard (i.e., 233 mm). The term "full-width" can be used to describe different widths for different card cages. As will be described below, for the card cage depicted in FIG. 2B, the term "full width" corresponds to a width of PCB module 20 (as depicted in FIG. 1B, adhering to the VMEbus 3U standard (100 mm). The term "full width" also can correspond to various other widths for various other card cages and for various other PCB module standards.

In FIG. 2A, card cage 34 of CCA assembly 30, is shown as having PCB modules 10A, 10B, and 10C received within card slots 42A, 42B, and 42C, respectively. Electronics enclosure 32 is designed to accommodate only PCB module, such as PCB modules 10A, 10B, and 10C, that adhere to such a VMEbus 6U standard. Thus, for the embodiment depicted in FIG. 2A, the term "full-width" is associated with VMEbus 6U standard sized PCB modules. Any PCB modules that have widths less than the width (i.e., 233mm) defined by the VME 6U standard would be called "reduced-width" PCB modules for the embodiment depicted in FIG. 2A. CCA assembly 30, as depicted in FIG. 2A, in not configured to receive such reduced-width PCB modules, as the pairs of slide members 44a and 44b, 46a and 46b, and 48a and 48b have separation distances that would be too large for such reduced-width PCB modules.

Each of PCB modules 10A, 10B, and 10C have been received within card cage 34 by slidably guiding PCB modules 10A, 10B, and 10C into card cage 34. For example, PCB modules 10A is slidably guided into card cage 34 by slidably engaging opposite lateral sides 12a and 12b of PCB module 10A with complimentary slide engagement members 44a and 44b on opposite lateral sides of card cage 34. Similarly, PCB modules 10B is slidably guided into card cage 34 by slidably engaging opposite lateral sides 12a and 12b of PCB module 10B with complimentary slide engagement members 46a and 46b on opposite lateral sides of card cage 34. And again, PCB modules 10C is slidably guided into card cage 34 by slidably engaging opposite lateral sides 12a and 12b of PCB module 10C with complimentary slide engagement members 48a and 48b on opposite lateral sides of card cage 34.

In FIG. 2B, CCA assembly 50 includes electronics enclosure 52, card cage 54, and external fins 36. In the embodiment depicted in FIG. 2B, card cage 54 has three full-width card slots 56A, 56B and 56C. For the FIG. 2B embodiment, the term "full-width" describes the width of PCB modules that can be received within CCA card cage 54 of CCA assembly 50. For example, in the FIG. 2B depiction, card cage 54 is designed to receive PCB modules 20A, 20B, and 20C within card slots 56A, 56B, and 56C, respectively. Each of PCB modules 20A, 20B, and 20C has a width of 100 mm, adhering to the VMEbus 3U standard. Electronics enclosure 52, as depicted in FIG. 2b, is designed to accommodate only boards adhering to such a VMEbus 3U standard. Thus, in the embodiment depicted in FIG. 2B, the term "full-width" is associated with VMEbus 3U standard sized PCB modules.

Each of PCB modules 20A, 20B, and 20C have been received within card cage 54 by slidably guiding PCB modules 20A, 20B, and 20C into card cage 54. For example, PCB module 20A is slidably guided into card cage 54 by slidably engaging opposite lateral sides 22a and 22b of PCB module 20A with slide engagement members 64a and 64b on opposite lateral sides of card cage 54. Similarly, PCB module 20B is slidably guided into card cage 54 by slidably engaging opposite lateral sides 22a and 22b of PCB module 20B with complimentary slide engagement members 66a and 66b on opposite lateral sides of card cage 54. And again, PCB modules 20C is slidably guided into card cage 54 by slidably engaging opposite lateral sides 22a and 22b of PCB module 20C with complimentary slide engagement members 68a and 68b on opposite lateral sides of card cage 54.

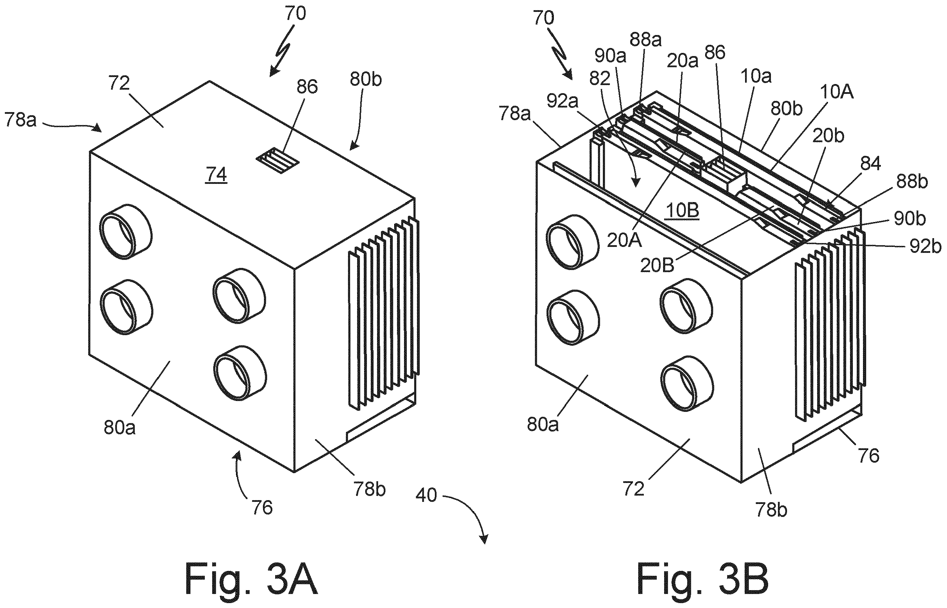

FIGS. 3A and 3B are perspective views of an electronics enclosure for a CCA assembly that is configured to receive mixed-width CCA modules. In FIG. 3A, CCA assembly 70 includes electronics enclosure 72, which has top face 74, backplane face 76, opposite lateral faces 78a and 78b, and opposite front and back faces 80a and 80b. In FIG. 3A, electronics enclosure 72 is depicted with top face 74 covering top opening 82, thereby isolating interior cavity 38 from exterior environment 40. In FIG. 3B, CCA assembly 70 is depicted with top face 74 removed, exposing top opening 82, thereby permitting PCB modules 10A, 10B, 20A, and 20B to be inserted into and/or removed from interior cavity 38. Various elements of CCA assembly 70 form card cage 84. For example, in the embodiment depicted in FIG. 3B, opposite lateral faces 78a and 78b of electronics enclosure 72 also serve as opposite lateral sides of card cage 84. In other embodiments, sides of card cage 84 are located within internal cavity 38 enclosed by electronics enclosure 72.

FIGS. 3A and 3B are perspective views of CCA assembly 70, which is similar to CCA assembly 30 depicted in the plan view of FIG. 2A. CCA assembly 70 also includes CCA module adapter 86, which is instrumental in permitting CCA assembly 70 to receive CCA modules of different widths, such as PCB modules 10A, 10B, 20A, and 20B. Card cage 84 includes first lateral side 78a and second lateral side 78b. Slide engagement members 88a, 90a, and 92a are distributed upon and attached to first lateral side 78a of card cage 84. Slide engagement members 88b, 90b, and 92b are distributed upon and attached to second lateral side 78b of card cage 84. Slide engagement member 88a is opposite to and paired with slide engagement member 88b, therebetween defining full-width card slot 94A. Because slide engagement members 88a and 88b define such a full-width card slot therebetween, slide engagement members 88a and 88b are described as being *full-width* slide engagement members 88a and 88b. In a similar way, slide engagement member 90a is opposite to and paired with slide engagement member 90b, therebetween defining full-width card slot 94B, and slide engagement member 92a is opposite to and paired with slide engagement member 92b, therebetween defining full-width card slot 94C.

The pair of full-width slide engagement members 88a and 88b are configured to slidably guide full-width PCB module 10A into and/or out of full-width card slot 94A. The pair of full-width slide engagement members 88a and 88b are also aligned with a complementary connector at the backplane face 76 of electronics enclosure 72, so that, when full-width PCB module 10A is fully inserted into full-width card slot 94A, connector 16 located on connector side 14a of PCB module 10A is electrically connected to the complementary connector on backplane face 76 of electronics enclosure 72.

Unlike full-length card slot 94A, however, full-length card slot 94B is unable to receive a full-length PCB module, such as full-length PCB module 10A. CCA module adapter 86 is interposed between full-width slide engagement members 90a and 90b, thereby blocking a portion of card slot 94B. Although CCA module adapter 86 blocks a portion of full-length card slot 94B, CCA module adapter also divides full-length card slot 94B into two reduced-width card slots 96A and 96B. CCA module adapter 86 includes card-slot dividing member 98, first and second electronics enclosure-engagement members 100a and 100b, and first and second reduced-width slide members 102a and 102b. Card-slot dividing member 98 longitudinally extends between first end 104a and second end 104b and is located directly between full-width slide engagement members 90a and 90b.

Electronics enclosure-engagement member 100a is at first end 104a of slot dividing member 98 and is configured to engage top face 74 of electronics enclosure 70, when top face 74 covers top opening 82, thereby isolating interior cavity 38 from exterior environment 40. Electronics enclosure-engagement member 100b is at second end 104b of slot dividing member 98 and is configured to engage backplane face 76 of electronics enclosure 72. First and second reduced-width slide members 102a and 102b are coupled to card-slot dividing member 96, each on opposite sides thereof. First reduced-width slide member 102a is opposite to and paired with full-width slide engagement member 90a, therebetween defining reduced-width card slot 96A, and second reduced-width slide engagement member 102b is opposite to and paired with slide engagement member 90b, therebetween defining reduced-width card slot 96B. Because card slots 96A and 96B have a reduced width (when compared with full-width card slots 94A and 94B, slide members 102a and 102b of CCA module adapter 86 are called *reduced-width* slide members 102a and 102b.

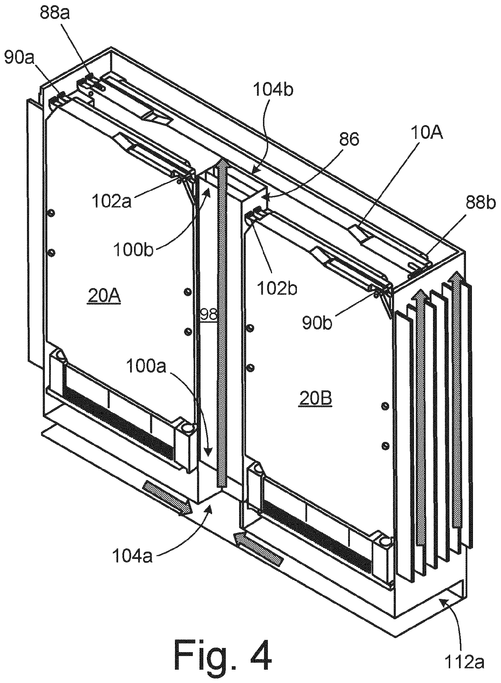

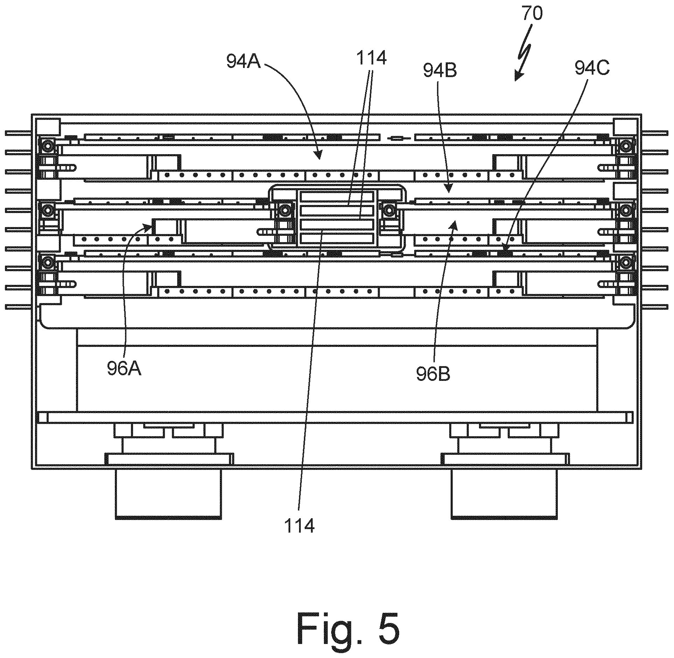

FIG. 4 is a sectional perspective view of the CCA assembly depicted in FIG. 1. FIG. 5 is a plan view of the CCA assembly depicted in FIG. 1. In FIGS. 4 and 5, CCA module adapter 86 can be seen as it traverses through interior cavity 38 of electronics enclosure 72. CCA module adapter 86 has lumen 108 extending between first and second end 104a and 104b of card-slot dividing member 96. Lumen 108 is configured to provide fluid path 110 through electronics enclosure 72. Fluid path 110 facilitates fluid flow from exterior atmosphere 40 between top face 74 and backplane face 76. To accomplish such fluid flow, top and backplane faces 74 and 76 have apertures 112a and 112b, respectively. electronics enclosure-engagement members 102a and 102b provide sealed coupling about apertures 112a and 112b, so that interior cavity 38 can be isolated from exterior environment 40. Providing fluid flow through electronics enclosure 72 facilitates cooling of any electronics operating within electronics enclosure 72. First and second electronics enclosure-engagement members 102a and 102b of CCA module adapter 86 are configured to sealably circumscribe first and second apertures 112a and 112b, respectively, thereby maintaining isolation of interior cavity 38 from exterior environment 40. Such a circumscribed seal can be obtained using o-rings, for example, that contact the top and backplane faces 74 and 76 about apertures 112a and 112b. Fins 114 extending within lumen 108 facilitate heat transfer from card-slot dividing member 96 to fluid flowing through fluid path 110. In some embodiments, fins extending from an exterior surface of card-slot dividing member 98 into interior cavity 38 of electronics enclosure can facilitate heat transfer from within interior electronics enclosure 38 to card-slot dividing member 98.

### Discussion of Possible Embodiments

The following are non-exclusive descriptions of possible embodiments of the present invention.

Some embodiments relate to a Circuit Card Assembly (CCA) module adapter for a card cage of an electronics enclosure. The CCA module adapter includes a card-slot dividing member, a pair of electronics enclosure-engagement members, and a pair of reduced-width slide members. The card-slot dividing member longitudinally extends between a first end and a second end and configured to be located directly between a pair full-width slide members coupled to opposite lateral sides of the card cage that define a full-width card slot therebetween. The pair of electronics enclosure-engagement members includes first and second electronics enclosure-engagement members at the first and second ends of the card-slot dividing member and configured to couple to a top face and a backplane face of the electronics enclosure, respectively. The pair of reduced-width slide members includes first and second reduced-width slide members coupled to the card-slot dividing member such that, when the card-slot dividing member is located directly between the first and second full-width slide members. The first reduced-width slide member is opposite the first full-width slide member, thereby defining a first reduced-width card slot. The second reduced-width slide member is opposite the second full-width slide member, thereby defining a second reduced-width card slot.

The CCA module adapter of the preceding paragraph can optionally include, additionally and/or alternatively, any one or more of the following features, configurations and/or additional components:

A further embodiment of the foregoing CCA module adapter, wherein each of the first and second reduced-width card slots can be configured to receive reduced-width PCB modules therein, the reduced-width PCB modules having a width commensurate with a distance between the reduced-width slide member and the full-width slide member defining the reduced-width card slot.

A further embodiment of any of the foregoing CCA module adapters, wherein the card-slot dividing member includes a lumen extending between the first and second ends. The first and second electronics enclosure-engagement members can be further configured to sealably circumscribe first and second apertures in the top and backplane faces, respectively, thereby providing a fluid path through the electronics enclosure and isolated from an interior cavity of the electronics enclosure.

A further embodiment of any of the foregoing CCA module adapters can further include thermally conductive fins projecting into the lumen, thereby increasing heat transfer between the card-slot dividing member and fluid flowing within the fluid path.

A further embodiment of any of the foregoing CCA module adapters can further include thermally conductive fins extending from outside surfaces of the card-slot dividing member into the interior cavity of the electronics enclosure, thereby increasing heat transfer between the card-slot dividing member and an atmosphere in the interior cavity of the electronics enclosure.

A further embodiment of any of the foregoing CCA module adapters, wherein the first and second reduced-width slide members can have a separation distance therebetween that is substantially equal to a difference between a first standard width of a first standard PCB module and two times a second standard width of a second standard PCB module.

A further embodiment of any of the foregoing CCA module adapters, wherein the first and second reduced-width slide members can have a separation distance therebetween that is substantially equal to a difference between a first standard width of a first standard PCB module and the sum of second and third standard widths of second and third standard PCB modules.

A further embodiment of any of the foregoing CCA module adapters, wherein the widths of the first, second, and third PCB modules can be standard widths corresponding to an industry recognized standard.

A further embodiment of any of the foregoing CCA module adapters, wherein the first and second electronics enclosure-engagement members can be flanges having engagement faces substantially parallel with the top and backplane faces of the electronics enclosure, respectively.

Some embodiments relate to an electronic housing, the electronic housing includes an electronics enclosure, a card cage, and a CCA module adapter. The electronics enclosure isolates an interior cavity from an exterior environment. The electronics enclosure has a top face and backplane face opposite to the top face. The card cage is within the electronics enclosure. The card cage has a plurality of full-width card slots therewithin. Each full-width card slot is defined between a pair of full-width slide member. The pair includes a first full-width slide member coupled to a first lateral side of the card cage and second full-width slide member opposite the first full-width slide member on a second lateral side opposite the first lateral side of the card cage. Each of the pair of full-width slide members configured to slidably guide a full-width PCB module therebetween. The CCA module adapter includes a card-slot dividing member and a pair of reduced-width slide members. The card-slot dividing member longitudinally extends between a first end having a first electronics enclosure engagement member coupled to the top face and a second end having a second electronics enclosure engagement member coupled to the backplane face. The card-slot dividing member is located directly between the pair of full-width slide members of a divided one of the full-width card slots. Each of the pair of reduced-width slide members is coupled to an opposite side of the card-slot dividing member, each pairing with one of the pair of full-width slide members of the divided one of the full-width card slots, thereby defining a reduced-width card slot therebetween. Each reduced-width card slot includes one of the full-width slide members of the divided one of the full-width card slot and one of the pair of reduced-width slide members there-opposite.

The electronic housing of the preceding paragraph can optionally include, additionally and/or alternatively, any one or more of the following features, configurations and/or additional components:

A further embodiment of the foregoing electronic housing can further include an o-ring that circumscribes an opening in the top face and configured to sealably engage a top cover, when closed.

A further embodiment of any of the foregoing electronic housings, wherein the card-slot dividing member can include a lumen extending between the first and second ends. The first and second engagement members can be further configured to sealably circumscribe first and second apertures in the top and backplane faces, respectively, thereby providing a fluid path through the electronics enclosure and isolated from the interior cavity of the electronics enclosure.

A further embodiment of any of the foregoing electronic housings can further include thermally conductive fins projecting into the lumen, thereby increasing heat transfer between the card-width reducing member and fluid flowing within the fluid path.

A further embodiment of any of the foregoing electronic housings can further include thermally conductive fins extending from outside surfaces of the card-width reducing member into the interior cavity of the electronics enclosure, thereby increasing heat transfer between the card-width reducing member and an atmosphere within the electronics enclosure.

A further embodiment of any of the foregoing electronic housings can further include a fan that forces air from the exterior environment through the lumen.

A further embodiment of any of the foregoing electronic housings, wherein the first and second reduced-width slide members can have a separation distance therebetween that is substantially equal to a difference between a first standard width of a first standard PCB module and two times a second standard width of a second standard PCB module.

A further embodiment of any of the foregoing electronic housings, wherein the first and second reduced-width slide members can have a separation distance therebetween that is substantially equal to a difference between a first standard width of a first standard PCB module and the sum of second and third standard widths of second and third standard PCB modules.

A further embodiment of any of the foregoing electronic housings, wherein the widths of the first, second, and third PCB modules can be standard widths corresponding to an industry recognized standard.

A further embodiment of any of the foregoing electronic housings, wherein the first and second electronics enclosure engagement members can be flanges having engagement faces parallel with the top and backplane faces of the electronics enclosure, respectively.

Some embodiments relate to a method for converting a PCB-module space of an electronics enclosure Card Circuit Assembly (CCA) so as to receive two PCB modules. In the method, a top face is coupled to a backplane face via first and second electronics enclosure engagement members at first and second ends of a card-width reducing member, respectively. The card-width reducing member is located directly between corresponding slide members on opposite interior surfaces of the electronics enclosure. In the method, a PCB module inserted into and/or removed from an interior cavity of the electronics enclosure is slidably guided via first and second PCB-module slide members coupled to the card-width reducing members together with the corresponding slide members on the opposite interior surfaces of the electronics enclosure. An electronics enclosure width defined between the corresponding slide members on the opposite interior surfaces of the electronics enclosure is reduced by the card-width reducing member and two PCB modules having reduced card widths can be slidably received within the electronics enclosure.

While the invention has been described with reference to an exemplary embodiment(s), it will be understood by those skilled in the art that various changes may be made without departing from the scope of the invention as defined by the claims. In addition, many modifications may be made to adapt a particular situation or material to the teachings of the invention without departing from the scope of the claims. Therefore, it is intended that the invention not be limited to the particular embodiment(s) disclosed, but that the invention will include all embodiments falling within the scope of the appended claims.

## Claims

1. A Card Circuit Assembly, CCA, module adapter for a card cage of an electronics enclosure, the CCA module adapter comprising:
a card-slot dividing member (98) longitudinally extending between a first end (104a) and a second end (104b) and configured to be located directly between a pair of full-width slide members (44a, 44b; 46a, 46b; 48a, 48b) coupled to opposite lateral sides of the card cage that define a full-width card slot therebetween;
first and second electronics enclosure-engagement members (100a, 100b) at the first and second ends of the card-slot dividing member and configured to couple to a top face (74) and a backplane face (76) of the electronics enclosure (70), respectively; and
first and second reduced-width slide members (102a, 102b) coupled to the card-slot dividing member such that, when the card-slot dividing member is located directly between the first and second full-width slide members, the first reduced-width slide member is opposite the first full-width slide member, thereby defining a first reduced-width card slot (96A), and the second reduced-width slide member is opposite the second full-width slide member, thereby defining a second reduced-width card slot (96B).

2. The CCA module adapter of claim 1, wherein each of the first and second reduced-width card slots are configured to receive reduced-width PCB modules (10) therein, the reduced-width PCB modules having a width commensurate with a distance between the reduced-width slide member and the full-width slide member defining the reduced-width card slot.

3. The CCA module adapter of claim 1 or 2, wherein the card-slot dividing member includes:
a lumen (108) extending between the first and second ends,
wherein the first and second electronics enclosure-engagement members are further configured to sealably circumscribe first and second apertures (112a, 112b) in the top and backplane faces, respectively, thereby providing a fluid path through the electronics enclosure and isolated from an interior cavity of the electronics enclosure.

4. The CCA module adapter of claim 3, further comprising;
thermally conductive fins (114) projecting into the lumen, thereby increasing heat transfer between the card-slot dividing member and fluid flowing within the fluid path, or
thermally conductive fins (36) extending from outside surfaces of the card-slot dividing member into the interior cavity of the electronics enclosure, thereby increasing heat transfer between the card-slot dividing member and an atmosphere in the interior cavity of the electronics enclosure.

5. The CCA module adapter of any preceding claim, wherein the first and second reduced-width slide members have a separation distance therebetween that is substantially equal to a difference between a first standard width of a first standard PCB module and two times a second standard width of a second standard PCB module, or wherein the first and second reduced-width slide members have a separation distance therebetween that is substantially equal to a difference between a first standard width of a first standard PCB module and the sum of second and third standard widths of second and third standard PCB modules, and optionally wherein the widths of the first, second, and third PCB modules are standard widths corresponding to an industry recognized standard.

6. The CCA module adapter of any preceding claim, wherein the first and second electronics enclosure-engagement members are flanges having engagement faces substantially parallel with the top and backplane faces of the electronics enclosure, respectively.

7. An electronics enclosure comprising:
an electronics enclosure (32) that isolates an interior cavity from an exterior environment, the electronics enclosure having a top face and backplane face opposite to the top face;
a card cage (34) within the electronics enclosure, the card cage having a plurality of full-width card slots (42A, 42B, 42C) therewithin, each full-width card slot defined between a pair of full-width slide members (44a, 44b; 46a, 46b; 48a, 48b), the pair having a first full-width slide member coupled to a first lateral side of the card cage and second full-width slide member opposite the first full-width slide member on a second lateral side opposite the first lateral side of the card cage, each pair of full-width slide members configured to slidably guide a full-width PCB module therebetween; and
a PCB-module adapter including:
a card-slot dividing member (98) longitudinally extending between a first end (104a) having a first electronics enclosure engagement member (100a) coupled to the top face (74) and a second end (104b) having a second electronics enclosure engagement member (100b) coupled to the backplane face (76), the card-slot dividing member located directly between the pair of full-width slide members of a divided one of the full-width card slots; and
a pair of reduced-width slide members (102a, 102b), each coupled to an opposite side of the card-slot dividing member, and each pairing with one of the pair of full-width slide members of the divided one of the full-width card slots, thereby defining a reduced-width card slot therebetween, each reduced-width card slot including one of the full-width slide members of the divided one of the full-width card slots and one of the pair of reduced-width slide members there-opposite.

8. The electronics enclosure of claim 7, further comprising:
an o-ring that circumscribes an opening in the top face and configured to sealably engage a top cover, when closed.

9. The electronics enclosure of claim 7 or 8, wherein the card-slot dividing member includes:
a lumen (108) extending between the first and second ends,
wherein the first and second engagement members are further configured to sealably circumscribe first and second apertures (112a, 112b) in the top and backplane faces, respectively, thereby providing a fluid path through the electronics enclosure and isolated from the interior cavity of the electronics enclosure.

10. The electronics enclosure of claim 9, further comprising;
thermally conductive fins (114) projecting into the lumen, thereby increasing heat transfer between the card-width reducing member and fluid flowing within the fluid path, or further comprising;
thermally conductive fins (36) extending from outside surfaces of the card-width reducing member into the interior cavity of the electronics enclosure, thereby increasing heat transfer between the card-width reducing member and an atmosphere within the electronics enclosure.

11. The electronics enclosure of claim 9 or 10, further comprising:
a fan that forces air from the exterior environment through the lumen.

12. The electronics enclosure of any of claims 7 to 11, wherein the first and second reduced-width slide members have a separation distance therebetween that is substantially equal to a difference between a first standard width of a first standard PCB module and two times a second standard width of a second standard PCB module., or
wherein the first and second reduced-width slide members have a separation distance therebetween that is substantially equal to a difference between a first standard width of a first standard PCB module and the sum of second and third standard widths of second and third standard PCB modules.

13. The electronics enclosure of claim 7, wherein the widths of the first, second, and third PCB modules are standard widths corresponding to an industry recognized standard.

14. The electronics enclosure of any of claims 7 to 13, wherein the first and second electronics enclosure engagement members are flanges having engagement faces parallel with the top and backplane faces of the electronics enclosure, respectively.

15. A method for dividing a full-width card slot of a Card Circuit Assembly, CCA, into two reduced-width card slots, the method comprising:
coupling, via first and second electronics enclosure engagement members (100a, 100b) at first and second ends of a card-width reducing member, to a top face (74) and a backplane face (76), respectively, and directly between corresponding slide members (102a, 102b) on opposite interior surfaces of the electronics enclosure; and
slidably guiding, via first and second PCB-module slide members coupled to the card-width reducing members together with the corresponding slide members on the opposite interior surfaces of the electronics enclosure, a PCB module inserted into and/or removed from an interior cavity of the electronics enclosure,
wherein an electronics enclosure width defined between the corresponding slide members on the opposite interior surfaces of the electronics enclosure is reduced by the card-width reducing member and two PCB modules having reduced card widths can be slidably received within the electronics enclosure.
